# EUROPÄISCHE PATENTSCHRIFT

(11) **EP 0 809 885 B1**
(45) Veröffentlichungstag und Bekanntmachung des Hinweises auf die Patenterteilung: **10.11.2004**
(21) Anmeldenummer: 96941057.0
(22) Anmeldetag: 02.12.1996
(51) Int. Cl.: H03K 3/57

(54) **SCHALTUNGSANORDNUNG ZUR SPEISUNG EINER IMPULSENDSTUFE**
CIRCUIT CONFIGURATION FOR FEEDING A PULSE OUTPUT STAGE
CIRCUIT POUR L'ALIMENTATION D'UN ETAGE DE SORTIE D'IMPULSIONS

(30) Priorität: 13.12.1995 DE 19546563
(43) Veröffentlichungstag der Anmeldung: 03.12.1997
(73) Patentinhaber: Vectronix AG, 9435 Heerbrugg (CH)
(72) Erfinder: RENZ, Norbert, A-6900 Bregenz (AT)
(74) Vertreter: Stamer, Harald, Dipl,-Phys.
(86) Internationale Anmeldenummer: PCT/EP1996/005325
(87) Internationale Veröffentlichungsnummer: WO 1997/022179

(56) Entgegenhaltungen:
- DE-A- 3 116 447
- DE-A- 3 629 349
- DE-A- 4 202 836

## Beschreibung

Die Erfindung betrifft eine Schaltungsanordnung zur Speisung einer Impulsendstufe mit den Merkmalen des Oberbegriffs der Ansprüche 1 bis 3.

Eine Schaltungsanordnung dieser Art ist aus DE 23 31 084 C2 bekannt. Die Induktivität ist als Sperrwandlerüberträger ausgebildet, bei dem die Primärwicklung eines Transformators mit einer Niederspannungsquelle über eine impulsgesteuerte Transistorschalteinrichtung verbunden ist. Die Sekundärwicklung ist mit dem Kondensator über eine Gleichrichteranordnung verbunden.

Die Impulssteuereinrichtung besteht aus einer Anordnung zur Vorgabe der Transistorbasisspannung und einem Rückführkreis vom Transformator zur Basis des Transistors. Diese bilden einen selbstschwingenden Kreis, in dem der Transistor periodisch von Steuerimpulsen während eines spezifischen Zeitintervalls leitend gesteuert wird. Die Dauer des Zeitintervalls kann durch Variation des Übersetzungsverhältnisses für die Basisspannung des Transistors oder Variation der Quettenspannung eingestellt werden. Sie bestimmt den im Transformator gespeicherten Energiebetrag, der in den Kondensator übertragen werden kann. Die aktuellen Steuerzeitpunkte des Transistors für den leitenden und sperrenden Zustand werden ausschließlich durch die primärseitigen Oszillatorbauteile und das Schwingkreisvefiatten im Sekundärkreis bestimmt.

Im gesperrten Zustand des Transistors wird die im Transformator gespeicherte Energie über die Sekundärwicklung in den Kondensator übertragen. Die Steuerimpulsfolge des Transistors wird auch zur Erzeugung von synchronen Steuerimpulsen im Entladepfad des Kondensators verwendet. Auch die Auslösung der Nutzimpulse hängt daher von den primärseitigen Oszillatorbauteilen ab.

Aus B. Stadler, "Die Ladungstransformation...", etz-Archiv, Bd. 2 (1980), H. 1, S. 25 bis 27, ist eine Schaltungsanordnung zur induktiven Aufladung eines kapazitiven Energiespeichers bekannt. Eine Spannungsquelle, die eine hohe Spannung bereitstellt, lädt direkt einen Kondensator über eine Induktivität auf die Spannung der Spannungsquelle auf. Durch Schließen eines Schalters wird der Kondensator in Form eines Nutzimpulses entladen, der zur gepulsten Anregung eines Gas-Lasers verwendet wird. Der Schalter öffnet sich danach selbst in Abhängigkeit vom Entladezustand des Kondensators. Die Amplitude des Entladepulses ist nicht einstellbar. Der Ladezyklus hängt von den Betriebsbedingungen ab.

Endstufen der eingangs genannten Art tiefem Spannungsimpulse mit geringem Innenwiderstand und ermöglichen beispielsweise die Energieversorgung von Verbrauchern, welche impulsförmig betrieben werden sollen. Solche Verbraucher sind unter anderem auch Impulsdiodenlaser. Für Dioden im Leistungsbereich von einigen zehn Watt Spitzenleistung werden hier typischerweise Impulsspannungen bis zu 100 Volt benötigt. Bei größeren Impulsleistungen sind noch weit höhere Spannungen nötig. Impulswiederholungsfrequenzen von mehreren 10kHz sind hierbei üblich. Zusätzlich wird eine Amplitudeneinstellung durch Ändern der Impulsspannung verlangt.

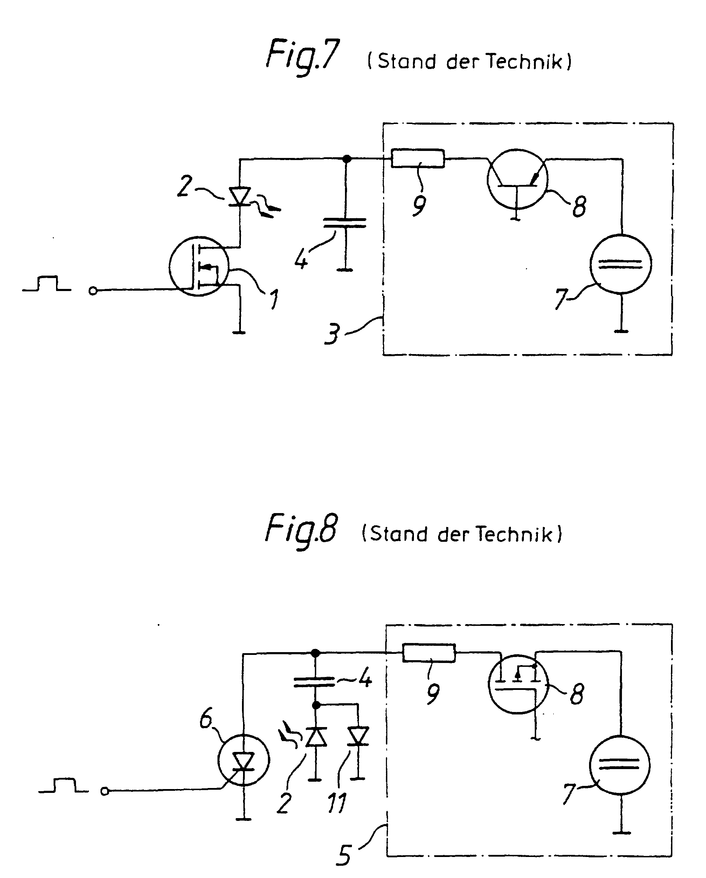

Für solche Endstufen werden häufig Thyristoren (vgl. Fa. UNITRODE Inc., Designnote 15) oder MOS-Leistungstransistoren, wie z. B. MOS-Feldeffekttransistoren (MOS-FET) eingesetzt (vgl. Fa. SILICONIX Inc., Applicationnote '6.13.10 Laser Diode Pulsers'). Eine solche überlicherweise verwendete Schaltungsanordnung, ist in Fig. 7 und 8 am Beispiel einer Ansteuerung für einen Diodenlaser zur Erläuterung dargestellt. Ein Diodenlaser 2 als Verbraucher, ein Kondensator 4 und eine Schalteinrichtung in der From eines MOS-FET 1 (Fig. 7) oder Thyristors 6 (Fig. 8) sind in Reihe geschaltet. Der Kondensator 4 wird durch eine Ladeschaltung 3 (Fig. 7) bzw. 5 (Fig. 8), auf eine geeignet hohe Spannung aufgeladen. Die Ladespannung wird von einer Spannungsquelle 7 bereitgestellt, die durch einen Transistor (Fig. 7) bzw. MOS-FET (Fig. 8) als Schaltelement 8 über einen Widerstand 9, welcher hier alle Zuleitungsimpedanzen und Innenwiderstände umfassen soll, an den Kondensator 4 geschaltet wird, wie es in Fig. 7 und 8 gezeigt ist. in Fig. 8 ist parallel zu dem Diodenlaser 2 eine Schutzdiode 11 gegenpolig geschaltet.

Wenn der MOS-FET 1 bzw. der Thyristor 6 angesteuert wird, schaltet dieser den Diodenlaser 2 an den aufgeladenen Kondensator 4. Dieser wird durch einen durch den Diodenlaser 2 und den MOS-FET 1 bzw. Thyristor 6 fließenden Stromimpuls fast vollständig entladen. Die emeute Aufladung des Kondensators 4 kann in den Impulspausen der Ansteuerimpufse vorgenommen werden.

Von Nachteil ist bei diesen Schaltungsanordnungen, daß in dem Widerstand 9 der Spannungsversorgung 3 bzw. 5 elektrische Energie verbraucht wird, welche der an den Kondensator 4 gelieferten entspricht, und daß somit der Wirkungsgrad verschlechtert wird. Dies ist besonders nachteilig, wenn die Hochspannung aus einer Spannungsquelle mit niedriger Spannung und beschränktem Energievorrat, wie sie bei kleinen, tragbaren Geräten vorkommt, mit endlichem Wirkungsgrad, erzeugt werden muß. Der Materialund Kostenaufwand dieser Hochspannungserzeugung schlägt ebenfalls nachteilig zu Buche.

Eine Amplitudeneinstellung kann auch bei hohen impulswiederholungsfrequenzen durchgeführt werden, indem das Schaltelement 8 durch ein pulsweitenmoduliertes Signal angesteuert wird, so daß durch die unterschiedliche Ladedauer der Kondensator 4 auf die entsprechende Endspannung geladen wird. Diese Endspannung ist nicht linear von der Ladedauer abhängig, sondern folgt einer Exponentialfunktion. Abhilfe würde eine zusätzliche Erhöhung der Hochspannung oder/und eine Konstantstromquellenschaltung bringen. Jedoch bringen der erhöhte Schaltungsaufwand und die weitere Verschlechterung des elektrischen Wirkungsgrades, verbunden mit zusätzlichem Kostenaufwand, weitere Nachteile mit sich. Nachteilig ist auch die Realisierung des schnellen elektronischen Schalters für die hohe Spannung, welcher ebenfalls Energieverluste und Kosten verursacht.

Der Erfindung lag die Aufgabe zugrunde, die Ladespannung des Kondensators für jeden Nutzimpuls unabhängig von der Pulswiederholfrequenz einstellen zu können.

Diese Aufgabe wird bei einer Schaltungsanordnung der eingangs genannten Art erfindungsgemäß durch die kennzeichnenden Merkmale der Ansprüche 1 bis 3 gelöst. Vorteilhafte Ausgestaltungen ergeben sich aus den Merkmalen der Ansprüche 4 bis 7.

In vorteilhafter Weise wird durch die erfindungsgemäße Schaltungsanordnung zur Speisung einer Impulsendstufe eine Energielieferung an eine Imputsendstufe in den impulspausen mit hohem Wirkungsgrad, besonders bei niedrigen Speisespannungen, ermöglicht Dabei ist keine zusätzliche Gleichspannungsquelle für die Hochspannung erforderlich. Ferner bietet die erfindungsgemäße Schaltungsanordnung eine einfache Möglichkeit, die Amplitude linear einstellen zu können, wodurch auch eine schnelle Einstellung von Impuls zu Impuls vorgenommen werden kann. Es ergibt sich insgesamt eine Material- und Kostenverringerung sowie eine Erhöhung des elektrischen Wirkungsgrades.

Der Erfindungsgegenstand wird im folgenden in beispielhafter Weise anhand von Ausführungsbeispielen unter Bezugnahme auf die Zeichnungen näher beschrieben, in denen
- Fig. 1: eine erste Ausführungsform der Erfindung zeigt,
- Fig. 2: Zeitdiagramme verschiedener Impulsformen der ersten Ausführungsform zeigt,
- Fig. 3: eine zweite Ausführungsform der Erfindung zeigt,
- Fig. 4: Zeitdiagramme verschiedener Impulsformen der zweiten Ausführungsform zeigt,
- Fig. 5: eine dritte Ausführungsform der Erfindung zeigt,
- Fig. 6: Zeitdiagramme verschiedener Impulsformen der dritten Ausführungsform zeigt,
- Fig. 7 und 8: jeweils eine Schaltungsanordnung zur Spannungsversorgung einer Impulsendstufe nach dem Stand der Technik zeigt.

In den Zeichnungen sind die gleichen Bauteile in den verschiedenen Figuren mit den gleichen Bezugszeichen bezeichnet.

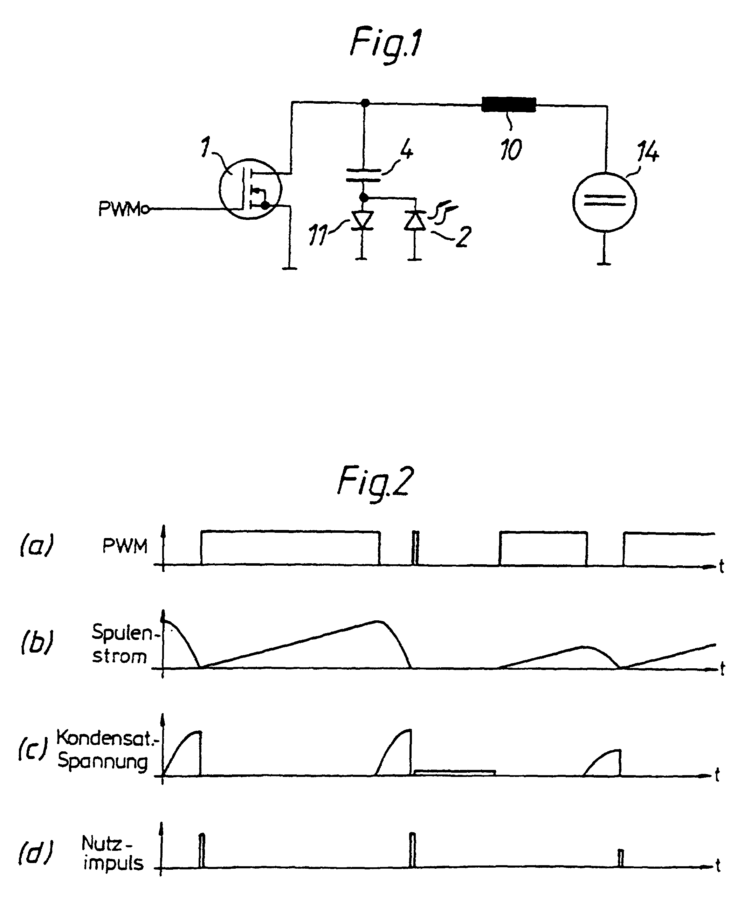

Unter Bezugnahme auf die Fig. 1 und 2 wird zunächst die Arbeitsweise der ersten Ausführungsform beschrieben, wobei angenommen wird, daß es sich bei den Bauteilen um ideale Bauteile handelt. Man erkennt, daß die schaltbare Endstufe der Fig. 1 mit der der Fig. 8 gemäß dem Stand der Technik mit der Ausnahme übereinstimmt, daß statt des Thyristors 6 als Schalteinrichtung 1 ein MOS-FET verwendet wird.

Grundsätzlich verschieden ist die Spannungsversorgung, die hier lediglich aus einer Niederspannungsquelle 14 besteht, wobei über eine eine Induktivität aufweisende Spule 10 eine Niederspannung von der Niederspannungsquelle 14 (z. B. 5 Volt einer Batterie) unmittelbar an die Impulsendstufe, also ohne nennenswerte Verluste, gelegt wird. Der als Schalteinrichtung 1 eingesetzte MOS-FET kann über pulsweitenmodulierte Impulse PWM angesteuert werden. In den Impulspausen wird der MOS-FET durchgeschaltet, so daß sich in der Spule 10 ein linear ansteigender Stromfluß aufbauen kann. Parallel dazu wird der Kondensator 4, der in einem vorangegangenen Zyklus bereits geladen worden ist, in Form des Nutzimpulses über den als Endstufe 2 verwendeten Diodenlaser impulsförmig entladen. Der Kondensator 4 bildet mit der Spule 10 einen Schwingkreis mit der Periodendauer T.

Wird der MOS-FET gesperrt, so steigt die Spannung am Kondensator 4 sinusförmig an und erreicht nach T/4 ihr Maximum, welches der zu erzeugenden Hochspannung entspricht. Die Höhe dieser Spannung hängt von der in der Spule 10 gespeicherten Energie und dem Verhältnis des Wertes der Spuleninduktivität zu dem Kapazitätswert des Kondensators 4 ab. Zum Zeitpunkt dieses Maximums sollte nun der MOS-FET wieder durchgeschaltet werden, um die günstigsten Arbeitsverhältnisse zu erreichen, und der Zyklus kann von neuem beginnen. Der Strom zum Zeitpunkt des Abschaltens des MOS-FET hängt linear von der Einschaltdauer ab, und die maximale Kondensatorspannung ist ebenfalls streng proportional zu diesem Strom. Somit kann durch eine veränderbare Einschaltdauer des MOS-FET (was einer Pulsweitenmodulation (PWM) entspricht) unabhängig von der Impulswiederholungsfrequenz auf einfache Weise eine linear reagierende Hochspannungseinstellung für jeden einzelnen Impuls vorgenommen werden.

Zur Ergänzung von Fig. 1 sind in Fig. 2 einige Signalverläufe wiedergegeben, wobei bei (a) unterschiedliche pulsweitenmodulierte Impulse, bei (b) der jeweils durch die Spule 10 fließende Strom, bei (c) die entsprechende Kondensatorspannung und bei (d) der Nutzimpuls gezeigt ist. Man erkennt, daß bei durchgeschaltetem MOS-FET die Spannung am Kondensator auf dem Bezugspotential ist, d.h. hier auf Masse. Die Schaltungsanordnung gemäß Fig. 1 zeichnet sich durch ihre Einfachheit aus. Da in der Praxis die Bauteile nicht ideal sind, treten Verluste auf, welche hauptsächlich auf die im Ladezweig 11 angeordnete Gleichricht- bzw. Schutzdiode, als auch auf den Einschaltwiderstand des MOS-FET und die Güte des Schwingkreises zurückzuführen sind. Wirkungsgrade von über 80%, bei vemünftiger Dimensionierung, sind ohne Schwierigkeiten zu erreichen. Moderne Bauteile sehr guter Qualität, wie zum Beispiel schnelle Kleinteistungs-MOS-FET mit EIN-Widerständen von weniger als 0,1 Ohm, werden inzwischen sehr preiswert auf dem Markt angeboten. Entsprechendes gift auch für die anderen Bauteile.

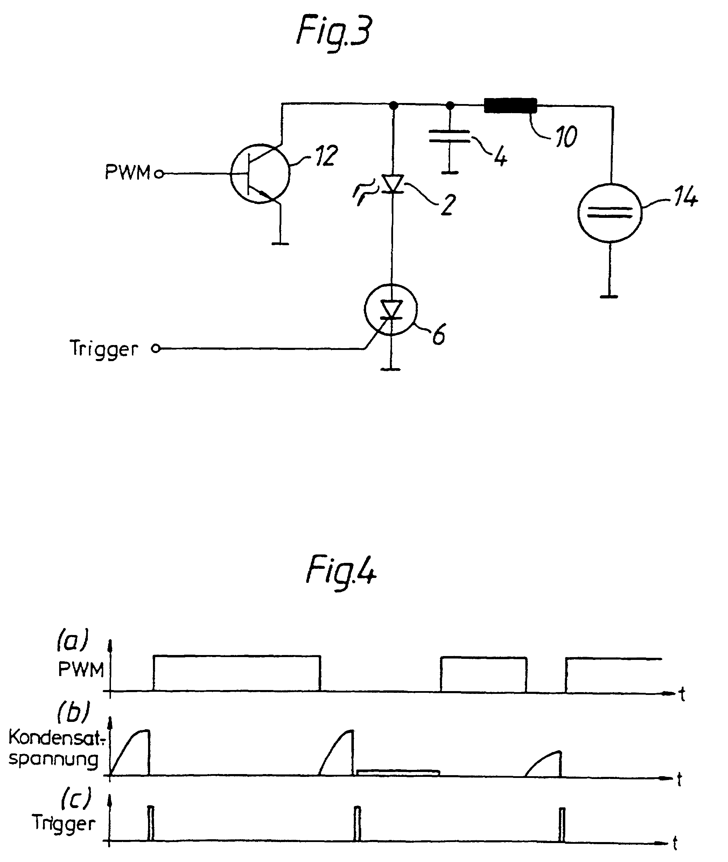

Bei der in Fig. 3 gezeigten Ausführungsform umfaßt die Endstufe 2 eine Reihenschaltung aus einem als triggerbarer Schalter 6 verwendeten Thyristor und einem Diodenlaser als Verbraucher. Der freie Anschluß des Diodenlasers ist mit einem Kondensator 4 verbunden. Der Verbindungspunkt von Diodenlaser und Kondensator 4 ist einerseits mit einer eine Induktivität aufweisenden Spule 10 und andererseits mit einem als Schalteinrichtung 12 verwendeten Transistor so verbunden, daß dieser parallel zu der Reihenschaltung aus Thyristor und Diodenlaser geschaltet ist. Die Spule 10 ist mit ihrem freien Anschluß mit einer Spannungsquelle 14 für eine Versorgungsspanung verbunden.

In der Schaltungungsanordnung der Fig. 3 wird die in der Spule 10 gespeicherte Energie nach Abschalten der Endstufe, wie oben beschrieben, in den Kondensator 4 geliefert. Dies setzt voraus, daß das Abschalten durch das Steuersignal kontrolliert werden kann, was z. B. im Falle einer Thyristorendstufe nicht gewährleistet ist, da der Thyristor erst wieder sperrt, wenn sein Haltestrom unterschritten wird.

Dieses Problem wird bei dieser Ausführungsform der Erfindung gelöst, indem zusätzlich zu dem pulsweitenmodulierten Signal PWM ein weiteres Trigger-Signal verwendet wird. Das pulsweitenmodulierte Signal PWM wird hier an die Basis des Transistors gelegt, um bei durchgeschaltetem Transistor der Spule 10 die Versorgungsspannung der Spannungsquelle 14 aufzuschalten. Das weitere Trigger-Signal wird als ein Auslösesignal an den Thyristor gelegt und nur für die Impulsauslösung verwendet.

Die vorstehend beschriebene Schaltungsanordnung kann bei allen Endstufen verwendet werden, bei denen die kombinierte Funktion, wie sie in Fig. 1 gezeigt ist, nicht geeignet ist. Im Falle der Endstufe mit Thyristor übernimmt dieser zusätzliche Transistor nun auch das Löschen des Thyristors. Die zusätzlichen Kosten sind vemachlässigbar, da dieser Transistor in der Regel ein Billigtyp sein kann.

Zur Ergänzung von Fig. 3 sind in Fig. 4 einige Signalverläufe wiedergegeben, wobei bei (a) pulsweitenmodulierte Impulse PWM, bei (b) die Spannung am Kondensator 4 und bei (c) der Trigger-Impuls gezeigt ist. Man erkennt, daß bei durchgeschaltetem Transistor die Spannung am Kondensator 4 auf dem Bezugspotential ist. d.h. hier auf Masse.

Aus den vorangegangenen Funktionsbeschreibungen geht hervor, daß die Nutzimpulsauslösung synchron zum Maximum der Kondensatorspannung erfolgen sollte, um ein bestmögliches Ergebnis zu erhalten. Aus verschiedenen Gründen ist die Forderung nach Synchronität von Nachteil, beispielsweise in dem Fall, wenn die Möglichkeit einer Frequenzmodulation bei der Impulserzeugung verlangt wird, oder wenn durch Probleme im zeitlichen Ablauf der Steuerung eine Phasenverschiebung bei der Impulserzeugung in bezug auf die Spulenansteuerung gefordert wird.

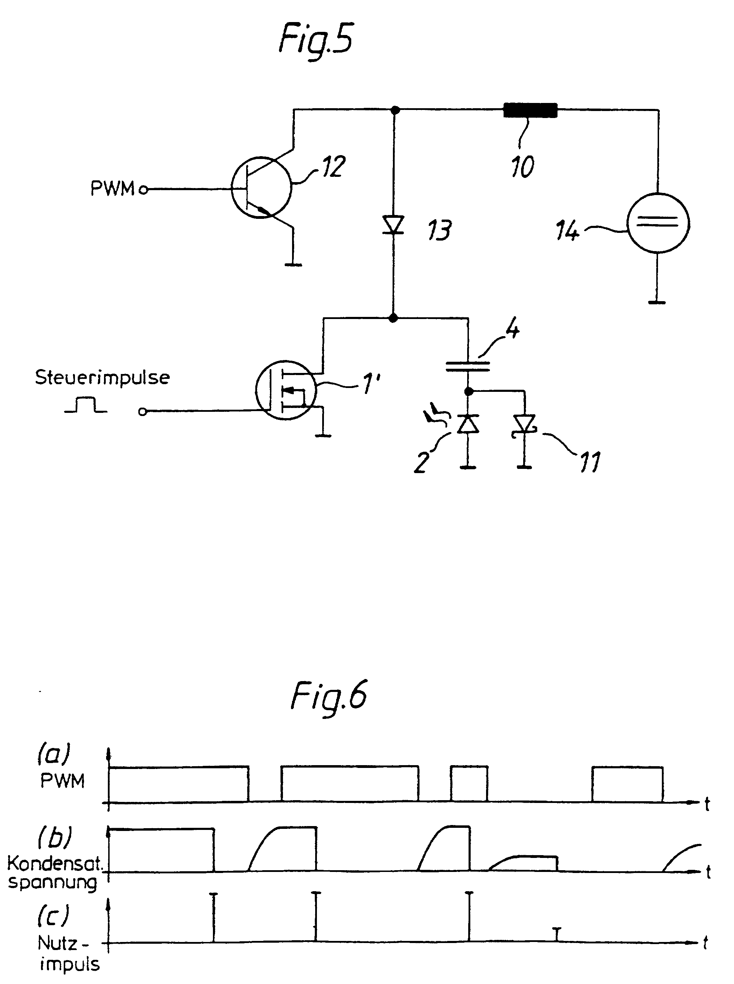

In Anlehnung an das Prinzip der Verwendung zweier Signale gemäß Fig. 3 kann, wie in Fig. 5 gezeigt ist, die erste Ausführungsform gemäß Fig. 1 so abgeändert werden, daß außerhalb der Zeit, während der die Energie aus der Spule 10 an den Kondensator 4 geliefert wird, zu einem beliebigen Zeitpunkt eine Impulserzeugung ausgelöst werden kann.

im Unterschied zu der Ausführungsform der Fig. 1 ist der Verbindungspunkt von Kondensator 4 und einem als zweite steuerbare Schalteinrichtung 1' vorgesehenen MOS-FET nicht direkt, sondern über eine Diode 13 mit der Spule 10 verbunden. Parallel zu der Impulsendstufe ist ein als Schalteinrichtung 12 vorgesehener Transistor geschaltet, der mit pulsweitenmodulierten Impulsen (PWM) angesteuert werden kann. Wenn der Transistor durchgeschaltet wird, wird der Spule 10 die Versorungsspannung der Spannungsquelle 14 aufgeschaltet. Ferner dient im Unterschied zu der Ausführungsform der Fig. 1 der MOS-FET hier ausschließlich der Auslösung eines Nutzimpulses, d.h. der Entladung des Kondensators 4 durch den Diodenlaser.

Zu einem beliebigen Zeitpunkt kann eine Impulsauslösung durch Ansteuern des MOS-FET ausgeführt werden, da die Kondensatorenergie durch die Diode 13 nicht mehr abfließen kann. Somit wird eine große Freiheit bei der Wahl der Nutzimpulslage und der zeitlichen Spulenansteuerung gewonnen, unabhängig davon, ob die Impulswiederholungsfrequenz ebenfalls auch noch variiert wird. Es muß nur darauf geachtet werden, daß die Zeit T/4 des Schwingkreises abgewartet wird. Lediglich Leckverluste führen zu einer Entladung, wenn die zeitlichen Impulsabstände zu groß werden. Durch diese zusätzliche Diode 13 wird jedoch der elektrische Wirkungsgrad wieder etwas verringert.

Zur Ergänzung von Fig. 5 sind in Fig. 6 einige Singalverläufe wiedergegeben, welche die große Flexibilität, die nun zur Verfügung steht, demonstrieren sollen. Bei (a) sind verschiedene pulsweitenmodulierte Impulse (PWM), bei (b) die Spannung am Kondensator 4 und bei (c) die Nutzimpulse gezeigt.

## Patentansprüche

1. Schaltungsanordnung zur Speisung einer Impulsendstufe mit Impulsen gleichbleibender Polarität,
- bei der eine Induktivität mittels einer steuerbaren Schalteinrichtung an eine Niederspannungsquelle anschaltbar ist,
- wobei beim Abschalten der Schalteinrichtung der Strom der Induktivität in einen Kondensator fließt und
- der Kondensator nach Erreichen seines Ladungsmaximums mit der Endstufe verbunden und in Form eines Nutzimpulses entladen wird,
**dadurch gekennzeichnet, daß**
- der Kondensator (4) in Serie mit der Endstufe (2) am Verbindungspunkt der als Spule (10) ausgebildeten Induktivität mit der Schalteinrichtung (1) liegt,
- der Endstufe (2) ein Ladezweig (11) für den Kondensator (4) parallel geschaltet ist,
- die Schalteinrichtung (1) einerseits zwecks Festlegung der Ladespannung des Kondensators (4) pulsweitenmoduliert (PWM) angesteuert wird und
- andererseits durch Ansteuern mit einem kurzen Impuls im Zeitpunkt der maximalen Kondensatorspannung einen Entladepfad für den Kondensator (4) zur Erzeugung des Nutzimpulses schließt.

2. Schaltungsanordnung zur Speisung einer Impulsendstufe mit Impulsen gleichbleibender Polarität,
- bei der eine induktivität mittels einer steuerbaren Schalteinrichtung an eine Niederspannungsquelle anschaltbar ist,
- wobei beim Abschalten der Schalteinrichtung der Strom der Induktivität in einen Kondensator fließt und
- der Kondensator nach Erreichen seines Ladungsmaximums mit der Endstufe verbunden und in Form eines Nutzimpulses entladen wird,
**dadurch gekennzeichnet, daß**
- der Kondensator (4) und die Endstufe (2) parallel am Verbindungspunkt der als Spule (10) ausgebildeten Induktivität und der Schalteinrichtung (12) liegen,
- die Schalteinrichtung (12) zwecks Festlegung der Ladespannung des Kondensators (4) pulsweitenmoduliert (PWM) angesteuert wird,
- zur Endstufe (2) ein triggerbarer Schalter (6) in Reihe liegt, der zum Zeitpunkt der maximalen Ladespannung des Kondensators (4) angesteuert wird.

3. Schaltungsanordnung zur Speisung einer Impulsendstufe mit Impulsen gleichbleibender Polarität,
- bei der eine Induktivität mittels einer steuerbaren Schalteinrichtung an eine Niederspannungsquelle anschaltbar ist,
- wobei beim Abschalten der Schalteinrichtung der Strom der Induktivität in einen Kondensator fließt und
- der Kondensator nach Erreichen seines Ladungsmaximums mit der Endstufe verbunden und in Form eines Nutzimpulses entladen wird,
**dadurch gekennzeichnet, daß**
- der Kondensator (4) in Serie mit der Endstufe (2) und einer Diode (13) am Verbindungspunkt der als Spule (10) ausgebildeten Induktivität mit der Schalteinrichtung (12) liegt,
- der Endstufe (2) ein Ladezweig (11) für den Kondensator (4) parallel geschaltet ist,
- die Schalteinrichtung (12) zwecks Festlegung der Ladespannung des Kondensators (4) pulsweitenmoduliert (PWM) angesteuert wird und
- eine zweite steuerbare Schalteinrichtung (1') zur Serienschaltung der Endstufe (2) und des Kondensators (4) parallel liegt, die einen Entladepfad für den Kondensator (4) zur Erzeugung des Nutzimpulses schließt.

4. Schaltungsanordnung nach einem der Ansprüche 1, 2 oder 3, **dadurch gekennzeichnet, daß** die Endstufe (2) ein Diodenlaser ist.

5. Schaltungsanordnung nach Anspruch 1 oder 3, **dadurch gekennzeichnet, daß** die steuerbare Schalteinrichtung (1, 1') ein MOS-FET ist.

6. Schaltungseinrichtung nach Anspruch 1 oder 3, **dadurch gekennzeichnet, daß** die Schalteinrichtung (12) ein Transistor ist.

7. Schaltungseinrichtung nach Anspruch 2, **dadurch gekennzeichnet, daß** der triggerbare Schalter (6) ein Thyristor ist.

## Claims

1. Circuit configuration for feeding a pulse output stage with pulses of constant polarity,
- in which an inductor can be switched by a controllable switching means to a low-voltage source,
- the current of the inductor flowing into a capacitor when the switching means is switched off and
- the capacitor being connected to the output stage after reaching its maximum charge and being discharged in the form of a useful pulse,
**characterized in that**
- the capacitor (4) is in series with the output stage (2) at the connection point of the inductor in the form of coil (10) with the switching means (1),
- a charging branch (11) for the capacitor (4) is connected parallel to the output stage (2),
- the switching means (1) on the one hand is actuated with pulse width modulation (PWM) for establishing the charging voltage of the capacitor (4) and
- on the other hand completes a discharge path for the capacitor (4) for production of the useful pulse by actuation with a short pulse at the time of the maximum capacitor voltage.

2. Circuit configuration for feeding a pulse output stage with pulses of constant polarity,
- in which an inductor can be switched by a controllable switching means to a low-voltage source,
- the current of the inductor flowing into a capacitor when the switching means is switched off and
- the capacitor being connected to the output stage after reaching its maximum charge and being discharged in the form of a useful pulse,
**characterized in that**
- the capacitor (4) and the output stage (2) are in parallel at the connecting point of the inductor in the form of coil (10) and of the switching means (12),
- the switching means (12) is actuated with pulse width modulation (PWM) for establishing the charging voltage of the capacitor (4),
- a triggerable switch (6) which is actuated at the time of the maximum charging voltage of the capacitor (4) is in series with the output stage (2).

3. Circuit configuration for feeding a pulse output stage with pulses of constant polarity,
- in which an inductor can be switched by a controllable switching means to a low-voltage source,
- the current of the inductor flowing into a capacitor when the switching means is switched off and
- the capacitor being connected to the output stage after reaching its maximum charge and being discharged in the form of a useful pulse,
**characterized in that**
- the capacitor (4) is in series with the output stage (2) and a diode (13) at the connecting point of the inductor in the form of coil (10) with the switching means (12),
- a charging branch (11) for the capacitor (4) is connected parallel to the output stage (2),
- the switching means (12) is actuated with pulse width modulation (PWM) for establishing the charging voltage of the capacitor (4) and
- a second controllable switching means (1') is parallel with the series circuit of the output stage (2) and of the capacitor (4) and completes a discharge path for the capacitor (4), for producing the useful pulse.

4. Circuit configuration according to any of Claims 1, 2 or 3, **characterized in that** the output stage (2) is a diode laser.

5. Circuit configuration according to Claim 1 or 3, **characterized in that** the controllable switching means (1, 1') is a MOS-FET.

6. Circuit configuration according to Claim 1 or 3, **characterized in that** the switching means (12) is a transistor.

7. Circuit configuration according to Claim 2, **characterized in that** the triggerable switch (6) is a thyristor.

## Revendications

1. Circuit pour l'alimentation d'un étage de sortie d'impulsions, founissant des impulsions de polarité constante,
- dans lequel une inductance est susceptible d'être branchée à une source basse tension au moyen d'un dispositif de commutation susceptible d'être commandé,
- sachant que lors de la mise hors-service du dispositif de commutation, le courant de l'inductance passe dans un condensateur, et
- le condensateur, une fois qu'il a atteint sa valeur maximale de charge, est relié à l'étage de sortie et déchargé sous forme d'une impulsion utile,
**caractérisé en ce que**
- le condensateur (4) est branché en série avec l'étage de sortie (2), au point de liaison entre l'inductance réalisée sous la forme d'une bobine (10) et le dispositif de commutation (1),
- une branche de charge (11), pour le condensateur (4), est branchée en parallèle à l'étage de sortie (2),
- le dispositif de commutation (1), d'une part, est commandé par modulation d'impulsions en largeur (PWM) dans le but de fixer la tension de charge du condensateur (4), et
- d'autre part, au moyen d'une commande utilisant une impulsion courte, au moment où la tension au condensateur est maximale, ferme un chemin de décharge pour le condensateur (4), afin de produire l'impulsion utile.

2. Circuit pour l'alimentation d'un étage de sortie d'impulsions présentant des impulsions de polarité constante,
- dans lequel une inductance est susceptible d'être branchée à une source basse tension au moyen d'un dispositif de commutation susceptible d'être commandé,
- sachant que, lors de la mise hors-service du dispositif de commutation, le courant de l'inductance passe dans un condensateur et
- le condensateur, une fois qu'il a atteint sa valeur maximale de charge, est relié à l'étage de sortie et déchargé sous forme d'une impulsion utile,
**caractérisé en ce que**
- le condensateur (4) et l'étage de sortie (2) sont branchés en parallèle, au point de liaison entre l'inductance réalisée sous la forme d'une bobine (10) et le dispositif de commutation (12),
- le dispositif de commutation (12) est commandé par modulation d'impulsions en largeur (PWM) dans le but de fixer la tension de charge du condensateur (4),
- un interrupteur (6), susceptible d'être déclenché, est branché en série par rapport à l'étage de sortie (2), interrupteur qui est commandé au moment où la tension de charge du condensateur(4) est maximale.

3. Circuit pour l'alimentation d'un étage de sortie d'impulsions présentant des impulsions de polarité constante,
- dans lequel une inductance est susceptible d'être branchée à une source basse tension au moyen d'un dispositif de commutation susceptible d'être commandé,
- sachant que, lors de la mise hors-service du dispositif de commutation, le courant de l'inductance passe dans un condensateur, et
- le condensateur, une fois qu'il a atteint sa valeur maximale de charge, est relié à l'étage de sortie et déchargé sous forme d'une impulsion utile,
**caractérisé en ce que**
- le condensateur (4) est branché en série avec l'étage de sortie (2) et avec une diode (13), au point de liaison de l'inductance, réalisée sous forme d'une bobine (10), et du dispositif de commutation (12),
- une branche de charge (11), pour le condensateur (4), est branchée en parallèle à l'étage de sortie (2),
- le dispositif de commutation (12) est commandé par modulation d'impulsions en largeur (PWM) dans le but de fixer la tension de charge du condensateur (4), et
- un deuxième dispositif de commutation (1'), susceptible d'être commandé, est branché en parallèle par rapport au montage en série de l'étage de sortie (2) et du condensateur (4), dispositif de commutation qui ferme un chemin de décharge pour le condensateur (4) afin de produire l'impulsion utile.

4. Circuit selon l'une des revendications 1, 2 ou 3, **caractérisé en ce que** l'étage de sortie (2) est un laser à diodes.

5. Circuit selon la revendication 1 ou 3, **caractérisé en ce que** le dispositif de commutation (1, 1') susceptible d'être commandé est un dispositif MOS-FET.

6. Circuit selon la revendication 1 ou 3, **caractérisé en ce que** le dispositif de commutation (12) est un transistor.

7. Circuit selon la revendication 2, **caractérisé en ce que** l'interrupteur (6) susceptible d'être déclenché est un thyristor.
